# EUROPÄISCHE PATENTSCHRIFT

(11) **EP 3 105 365 B1**
(45) Veröffentlichungstag und Bekanntmachung des Hinweises auf die Patenterteilung: **01.05.2019**
(21) Anmeldenummer: 15701772.4
(22) Anmeldetag: 28.01.2015
(51) Int. Cl.: C23C 26/00, B05D 1/34, B22F 7/04, B22F 3/00

(54) **ANORDNUNG ZUM AUFBRINGEN VON LEITENDEN NANOPARTIKELN AUF EIN SUBSTRAT**
ARRANGEMENT FOR APPLYING CONDUCTIVE NANOPARTICLES ONTO A SUBSTRATE
ENSEMBLE SERVANT À APPLIQUER DES NANOPARTICULES CONDUCTRICES SUR UN SUBSTRAT

(30) Priorität: 10.02.2014 DE 102014101588
(43) Veröffentlichungstag der Anmeldung: 21.12.2016
(73) Patentinhaber: Pac Tech - Packaging Technologies GmbH, 14641 Nauen (DE)
(72) Erfinder: AZHDAST, Mohammad Hossein, 13585 Berlin (DE)
(74) Vertreter: Weisse, Renate
(86) Internationale Anmeldenummer: PCT/EP2015/051701
(87) Internationale Veröffentlichungsnummer: WO 2015/117872

(56) Entgegenhaltungen:
- DE-A1-102007 005 817
- DE-A1-102010 018 073
- DE-A1-102010 055 404
- JP-A- 2006 122 845

## Beschreibung

### Technisches Gebiet

Die Erfindung betrifft eine Anordnung zum Aufbringen von Nanopartikeln aus Metall oder Halbleitermaterial auf einen Wafer oder ein anderes Substrat.

Beispielsweise bei der Photolitographie werden metallische Nanopartikel als Keime auf ein Substrat aufgebracht. An diesen Keimen können metallische Leiterbahnen wachsen, wenn weiteres metallisches Material aufgebracht wird. Es gibt verschiedene Verfahren zum Aufbringen der metallischen Nanopartikel. Ein übliches Verfahren ist das Aufdampfen.

Typischerweise werden Metalle mit besonderen Eigenschaften verwendet. Zu diesen Metallen gehören Gold, Palladium, Kupfer, Aluminium, Nickel, Silber und Zinn. Die Metalle sind teuer und mehr oder weniger giftig. Beim Aufdampfen derartiger Metalle besteht die Gefahr, dass Material verloren geht. Zudem besteht die Gefahr, dass die Metalle eingeatmet werden oder auf die Haut von Personen gelangt, die mit den Metallen in Berührung kommen. Dann besteht eine Gefahr für die Gesundheit.

Aus der DE 10 2010 018 073 A1, DE 10 2010 055 404 A1 und JP 2006 612 2845 ist die Laserablation in Flüssigkeiten bekannt.

### Offenbarung der Erfindung

Es ist Aufgabe der Erfindung, eine Anordnung zum gleichmäßigen Aufbringen von Nanopartikeln aus Metall auf einen Wafer oder ein anderes Substrat eingangs genannten Art zu schaffen, bei dem praktisch kein metallisches Material verloren geht und die Gefahr für die Gesundheit reduziert wird.

Erfindungsgemäß wird die Aufgabe gelöst durch eine Anordnung mit den Merkmalen der Ansprüche 1 oder 7.

Bei einer solchen Anordnung werden die Nanopartikel von einem Metall- oder Halbleiterteil innerhalb der Flüssigkeit mit einem Laser oder Teilchenstrahler abgetragen. Sie können also nicht frei herumfliegen und verloren gehen. Es gibt keine giftigen Metalldämpfe. Der Materialverbrauch ist gering. Die Nanopartikel verbleiben in der Flüssigkeit und werden gemeinsam mit der Flüssigkeit auf das Substrat aufgetragen.

Bei der Erfindung ist die Flüssigkeit von einem aushärtbaren Polymer oder einem anderen aushärtbaren Kunststoff gebildet. Ein Beispiel für ein geeignetes Polymer ist eine Epoxid-Verbindung oder Benzocyclobuten. Bei diesen Materialien handelt es sich um fotosensible Materialien für die Verwendung in der Photolitographie. Sie können leicht abgeätzt werden. Dabei ist sowohl eine positive als auch eine negative Belichtung möglich. Das Polymer sorgt nicht nur dafür, dass die Metallpartikel beim Auftragen nicht von der Substratoberfläche wegspringen, sondern auch für eine gute Haftung für anschließend aufzutragende Komponenten.

Vorzugsweise ist das Metall Gold, Silber, Kupfer, Paladium, Aluminium, Nickel, Zinn oder eine Legierung dieser Metalle. Diese Metalle sind gute Leiter und daher für die Verwendung bei der Herstellung von Halbleiterprodukten etwa bei Wafern und andere Substrate gut geeignet. Es versteht sich, dass auch andere Metalle verwendet werden können, wenn dies von der Applikation gefordert ist.

Bei der Erfindung weist die Anordnung strömungserzeugende Mittel auf zum Erzeugen einer Flüssigkeitsströmung in dem Bereich, in dem die Nanopartikel von den Metall- oder Halbleiterteilen abgetragen werden. Die strömungserzeugenden Mittel können von einer Pumpe gebildet sein. Die strömungserzeugenden Mittel können auch einen Ultraschallhammer umfassen, der die Flüssigkeit durch eine Passage mit verringertem Durchmesser presst. Durch die strömungserzeugenden Mittel wird sichergestellt, dass bei gleicher Laserstrahlung der Gehalt der Nanopartikel in der Flüssigkeit gleichmäßig verteilt ist.

Bei einer Ausgestaltung der Erfindung ist eine Düse zum Auftragen der die Nanopartikel enthaltenden Flüssigkeit auf das Substrat vorgesehen. Mit der Düse kann die Flüssigkeit gleichmäßig dünn und sehr gezielt auf das Substrat aufgetragen werden.

Dabei sind die Metall- oder Halbleiterteile im Bereich vor der Düse angeordnet. Die Nanopartikel werden also unmittelbar nach dem Abtragen von dem Metall- oder Halbleiterteil durch die Düse geleitet und auf das Substrat aufgetragen. Sie können sich nicht innerhalb der Anordnung festsetzen oder ansammeln.

Bei einer weiteren Ausgestaltung der Erfindung ist die Düse an ein geschlossenes Reservoir angeformt, wobei das Reservoir einen Flüssigkeitseinlass aufweist, durch den unter Druck stehende Flüssigkeit in das Reservoir eintritt. Das Reservoir kann insbesondere laserseitig mit einer Glasplatte oder anderen transparenten Abdeckung verschlossen sein. Durch die Abdeckung tritt das Laserlicht in das Reservoir ein. Da Flüssigkeit wenig kompressibel ist, führt jeder Druck, der auf die Flüssigkeit ausgeübt wird, dazu, dass Flüssigkeit durch die Düse nach außen austritt.

Ausgestaltungen der Erfindung sind Gegenstand der Unteransprüche. Ausführungsbeispiele sind nachstehend unter Bezugnahme auf die beigefügten Zeichnungen näher erläutert.

### Kurze Beschreibung der Zeichnungen

- Fig.1: ist eine schematische Darstellung eines ersten Ausführungsbeispiels.
- Fig.2: ist eine schematische Darstellung eines zweiten Ausführungsbeispiels.

### Beschreibung der Ausführungsbeispiele

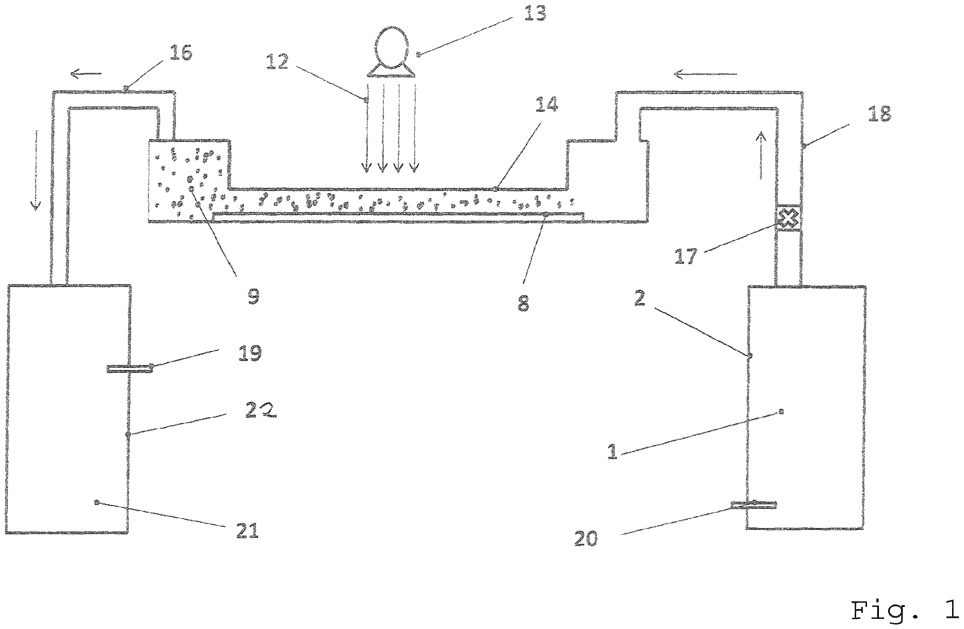

Figur 1 ist eine schematische Darstellung einer Anordnung zur Erzeugung von metallischen Nanopartikeln. Die Anordnung weist ein Reservoir 2 auf, in dem ein mit 1 bezeichnetes, flüssiges Polymer, beispielsweise eine Epoxid-Verbindung vorgesehen ist. Ein am Reservoir 2 vorgesehener Sensor zur Erfassung der Polymerdichte ist mit 20 bezeichnet. Die Polymermasse wird mit einer Pumpe 17 in Richtung der Pfeile durch eine Leitung 18 gefördert. Die Leitung 18 mündet in einer Kammer 14. Am Boden der Kammer 14 ist ein Metall- oder Halbleiterteil 8 angeordnet. Je nach Anwendung besteht das Metall- oder Halbleiterteil 8 aus Gold (Au), Silber (Ag), Kupfer (Cu), Paladium (Pd), Aluminium (Al), Nickel (Ni), Zinn (Sn) oder eine Legierung dieser Metalle. Es besteht weiterhin die Möglichket ein Silizium-basiertes Halbleitermaterial zu verwenden. Die Oberfläche des Metall- oder Halbleiterteils 8 wird von dem Polymer umspült. Die Oberseite der Kammer 14 ist mit einer Glasplatte verschlossen. Oberhalb der Kammer 14 ist ein Laser mit einem Scanning-System 13 angeordnet. Der Laserstrahl 12 wird durch die Glasplatte der Kammer 14 auf das Metall- oder Halbleiterteil 8 gerichtet. Mit dem Laserstrahl 12 werden Metallpartikel (Nanopartikel) von der Oberfläche des Metall- oder Halbleiterteils 8 abgetragen. Die durch den Ablationsprozess abgetragenen Nanopartikel werden von der Polymerflüssigekeit aufgenommen.

Die Kammer 14 hat im Bereich des Laserstrahls 12 eine verringerte Dicke. Dadurch wird einerseits erreicht, dass der Laserstrahl 12 nur geringfügig am Polymer absorbiert wird. Andererseits wird eine erhöhte Strömungsgeschwindigkeit erreicht. Abgetragene Metallpartikel können sich daher nicht festsetzen oder absinken.

Durch die Pumpe 17 wird die Polymerflüssigkeit unter Aufnahme der abgetragenen Partikel durch eine Ausgangsleitung 16 zu einem zweiten Reservoir 22 geleitet. In dem zweiten Reservoir wird das Polymer mit den Nanopartikeln 21 gesammelt und steht dort zur weiteren Verwendung zur Verfügung. Ein Sensor 19 im Reservoir 22 ermittelt die Dichte der Nanopartikel im Reservoir.

Die Polymerflüssigkeit mit den Nanopartikeln aus dem Reservoir 22 kann beispielsweise zur Umverdrahtung auf der Wafer- sowie Substratoberfläche eingesetzt werden. Bei diesem Ausführungsbeispiel kann die Polymerflüssigkeit mit den Nanopartikeln, beispielsweise durch spin coating auf das Substrat aufgetragen werden. Das Material kann anschließend mit einer Maske photolitographisch strukturiert werden. Ausgehärtetes Polymer in den Struktur-Zwischenräumen kann auf übliche Weise durch Ätzen oder Waschen entfernt werden. Auf diese Weise werden sehr feine Strukturen erreicht.

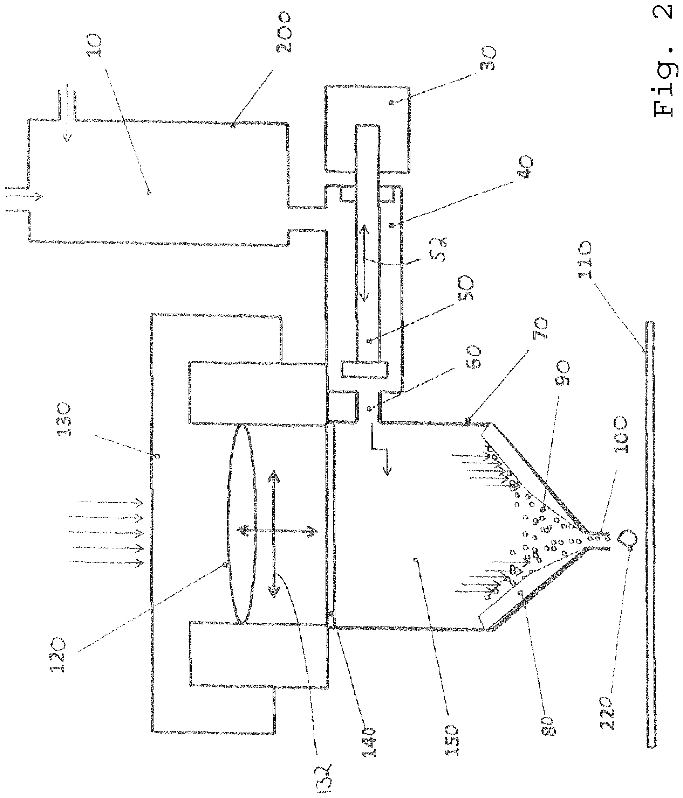

Figur 2 zeigt eine Anordnung, bei der die Polymerflüssigkeit mit den Nanopartikeln direkt auf ein Substrat aufgetragen wird. Polymerflüssigkeit 10 befindet sich in einem Reservoir 200. Am unteren Ende des Reservoirs 200 ist ein Ausgang vorgesehen. Der Ausgang mündet in einer langgestreckten Kammer 40. In der Kammer 40 sitzt ein Hammer 50. Der Hammer 50 wird mit einem Ultraschallgenerator 30 in Richtung des Pfeils 52 hin- und herbewegt. Über einen schmalen Kanal 60 ist die Kammer 40 mit einer Kammer 150 verbunden. Die Kammer 150 ist am unteren Ende konisch verjüngt. Dort ist eine Kapillare oder Düse 100 angeformt. Unterhalb der Düse 100 ist ein Substrat 110 angeordnet. Das Substrat 110 oder die Düse 100 oder beide sind derart beweglich, dass Material, welches aus der Düse austritt, auf die gewünschte Stelle auf dem Substrat aufgetragen wird.

Im konischen unteren Bereich der Kammer 150 sind Metall- oder Halbleiterteile 80 angeordnet. Die Kammer 150 ist oben mit einer Glasplatte 140 verschlossen. Laserlicht kann mit einem schnellen Scanner, z.B basierend auf einem akusto-optischen Modulator 130 in Richtung der Pfeile 132 in x- und y- Richtung bewegt werden. Das Laserlicht strahlt durch die Glasplatte 140 und das Polymer 150 auf die Metall- oder Halbleiterteile 80. Dort werden Nanopartikel 90 mittels Laserablation abgetragen. Die abgetragenen Nanopartikel 90 werden vom Polymer aufgenommen. Wenn der Hammer 50 nach links in der Darstellung bewegt wird, wird frisches Polymer ohne Nanopartikel durch den Kanal 60 gepresst. Dadurch wird in der Kammer 150 ein Druck erzeugt. Polymerflüssigkeit mit Nanopartikeln 90 wird durch die Düse 100 als Tropfen 220 nach außen abgegeben und auf das Substrat 110 aufgebracht. Das auf das Substrat 110 aufgebrachte Polymer härtet anschließend aus. Dieses Ausführungsbeispiel hat den Vorteil, dass die Leiterbahnen ohne Maske und photolitographische Verfahren hergestellt werden können. Die Nanopartikel werden mit dem Polymer direkt auf das Substrat aufgetragen.

Die vorstehend beschriebene Anordnung wurde detailliert beschrieben. Es versteht sich aber, dass dies nicht limitierend für den Schutzumfang des Patents sein soll, der ausschließlich durch die Patentansprüche bestimmt wird. Viele Alternativen und gleichwirkende Mittel sind dem Fachmann geläufig, die eingesetzt werden können, ohne vom Erfindungsgedanken abzuweichen. Insbesondere können vereinzelt die geometrische Anordnung, Materialien, Abmessungen und Mengen variieren ohne vom Erfindungsgedanken abzuweichen.

## Patentansprüche

1. Anordnung zum Aufbringen von Nanopartikeln aus Metall oder Halbleitermaterial auf einen Wafer oder ein anderes Substrat (110), enthaltend
(a) ein Flüssigkeitsreservoir (14, 150) mit einer Flüssigkeit;
(b) ein in dem Flüssigkeitsreservoir (14, 150) angeordnetes Metall- oder Halbleiterteil (8, 80);
(c) einen Laser (13) zum Abtragen von Nanopartikeln von dem Metall- oder Halbleiterteil innerhalb der Flüssigkeit in dem Flüssigkeitsreservoir (14, 150); und
(d) Mittel (100) zum Aufbringen der die abgetragenen Metallpartikel enthaltenden Flüssigkeit auf das Substrat
**dadurch gekennzeichnet, dass**
(e) der Wafer oder das andere Substrat (110) außerhalb des Flüssigkeitsreservoirs (14, 150) angeordnet ist;
(f) die Flüssigkeit (1, 10) von einem aushärtbaren Polymer oder einem anderen aushärtbaren Kunststoff gebildet ist,
(g) das Flüssigkeitsreservoir eine Kammer (150) umfasst, die am unteren Ende konisch verjüngt ist und an deren unteren Ende eine Kapillare oder eine Düse (100) zum Auftragen der die Nanopartikel enthaltenden Flüssigkeit auf das Substrat (110) vorgesehen ist, wobei Metall- oder Halbleiterteile (80) in dem Flüssigkeitsreservoir im konischen Bereich vor der Düse (100) angeordnet sind, und
(h) strömungserzeugende Mittel (17, 30, 50) zum Erzeugen einer Flüssigkeitsströmung in dem Bereich vorgesehen sind, in dem die Nanopartikel von den Metall- oder Halbleiterteilen (8, 80) abgetragen werden.

2. Anordnung nach Anspruch 1, **dadurch gekennzeichnet, dass** das Metall (8, 80) Gold, Silber, Kupfer, Paladium, Aluminium, Nickel, Zinn, eine Legierung dieser Metalle oder ein Silizium-basierter Halbleiter ist.

3. Anordnung nach Anspruch 1 oder 2, **dadurch gekennzeichnet, dass** die strömungserzeugenden Mittel von einer Pumpe (17) gebildet sind.

4. Anordnung nach Anspruch 1 oder 2, **dadurch gekennzeichnet, dass** die strömungserzeugenden Mittel einen Ultraschallhammer (50) umfassen, der die Flüssigkeit durch eine Passage (60) mit verringertem Durchmesser presst.

5. Anordnung nach einem der vorgehenden Ansprüche, **dadurch gekennzeichnet, dass** die Düse (100) an ein geschlossenes Reservoir (150) angeformt ist, wobei das Reservoir einen Flüssigkeitseinlass (60) aufweist, durch den unter Druck stehende Flüssigkeit in das Reservoir eintritt.

6. Anordnung nach einem der vorgehenden Ansprüche, **dadurch gekennzeichnet, dass** das Reservoir laserseitig mit einer Glasplatte oder anderen transparenten Abdeckung verschlossen ist.

7. Anordnung zum Aufbringen von Nanopartikeln aus Metall oder Halbleitermaterial auf einen Wafer oder ein anderes Substrat (110), enthaltend
(a) ein Flüssigkeitsreservoir (14, 150) mit einer Flüssigkeit;
(b) ein in dem Flüssigkeitsreservoir (14, 150) angeordnetes Metall- oder Halbleiterteil (8, 80);
(c) einen Laser (13) zum Abtragen von Nanopartikeln von dem Metall- oder Halbleiterteil innerhalb der Flüssigkeit in dem Flüssigkeitsreservoir (14, 150); und
(d) Mittel (100) zum Aufbringen der die abgetragenen Metallpartikel enthaltenden Flüssigkeit auf das Substrat
**dadurch gekennzeichnet, dass**
(e) der Wafer oder das andere Substrat (110) außerhalb des Flüssigkeitsreservoirs (14, 150) angeordnet ist;
(f) die Flüssigkeit (1, 10) von einem aushärtbaren Polymer oder einem anderen aushärtbaren Kunststoff gebildet ist,
(g) das Flüssigkeitsreservoir von einer Kammer (14) gebildet ist, in welche das Polymer oder der Kunststoff mit einer Pumpe aus einem Reservoir (2) in eine förderbar ist; und
(h) die Kammer (14) im Bereich des Laserstrahls (12) eine verringerte Dicke hat.

8. Anordnung nach Anspruch 7, **dadurch gekennzeichnet, dass** das Metall- oder Halbleiterteil (8) am Boden der Kammer (14) angeordnet ist, die Oberseite der Kammer (14) mit einer Glasplatte verschlossen ist und der Laserstrahl (12) durch die Glasplatte der Kammer (14) auf das Metall- oder Halbleiterteil (8) gerichtet ist.

## Claims

1. Assembly for placing nanoparticles of metal or semiconductor material on a wafer or any other substrate (110), comprising
(a) a liquid reservoir (14, 150) with a liquid;
(b) a metal- or semiconductor piece (8, 80) present in the liquid reservoir (14, 150);
(c) a laser (13) for removing nanoparticles from the metal- or semiconductor piece inside the liquid in the liquid reservoir (14, 150); and
(d) means (100) for placing the liquid comprising the metal particles on the substrate
**characterized in that**
(e) the wafer or the other substrate (110) is positioned outside the liquid reservoir (14, 150);
(f) the liquid (1, 10) is a curable polymer or any other curable plastic material,
(g) the liquid reservoir comprises a chamber which conically narrows at its lower end and which comprises a capillary or a jet (100) for placing the liquid comprising the nanoparticles on the substrate (110), wherein the metal- or semiconductor pieces (80) are positioned in the conical range before the jet (100), and
(h) flow generating means (17, 30, 50) are provided for generating a liquid flow in the range where nano particles are removed from the metal- or semiconductor portions (8, 80).

2. Assembly according to claim 1, **characterized in that** the metal (8, 80) is gold, silver, copper, palladium, aluminum, nickel, tin, an alloy of such metals or a silicon based semiconductor.

3. Assembly according to claim 1 or 2, **characterized in that** the flow generating means are a pump (17).

4. Assembly according to claim 1 or 2, **characterized in that** the flow generating means comprise an ultrasound hammer (50) pressing the liquid through a passage (60) with a reduced diameter.

5. Assembly according to any of the preceding claims, **characterized in that** the jet (100) is integrated into a closed reservoir (150), wherein the reservoir is provided with a liquid inlet (60) where pressurized liquid enters into the reservoir.

6. Assembly according to any of the preceding claims, **characterized in that** the reservoir is closed by a glass plate or another transparent cover on the side of the laser.

7. Assembly for placing nanoparticles of metal or semiconductor material on a wafer or any other substrate (110), comprising
(a) a liquid reservoir (14, 150) with a liquid;
(b) a metal- or semiconductor piece (8, 80) present in the liquid reservoir (14, 150);
(c) a laser (13) for removing nanoparticles from the metal- or semiconductor piece inside the liquid in the liquid reservoir (14, 150); and
(d) means (100) for placing the liquid comprising the metal particles on the substrate
**characterized in that**
(e) the wafer or the other substrate (110) is positioned outside the liquid reservoir (14, 150);
(f) the liquid (1, 10) is a curable polymer or any other curable plastic material, and
(g) the liquid reservoir is a chamber (14) with a pump for pumping the polymer or the plastic material from a reservoir (2) into the chamber (14); and
(h) the chamber (14) has a reduced width in the range of the laser beam (12).

8. Assembly according to claim 7, **characterized in that** the metal- or semiconductor piece (8) is positioned at the bottom of the chamber (14), the upper side of the chamber (14) is covered by a glass plate and the laser beam (12) is directed through the glass plate of the chamber (14) to the metal- or semiconductor piece (8).

## Revendications

1. Disposition destinée à appliquer des nanoparticules composées de métal ou d'un matériau semi-conducteur sur une galette de silicium ou un autre substrat (110), comprenant
(a) un réservoir de liquide (14, 150) contenant un liquide ;
(b) un élément de métal ou de semi-conducteur (8, 80) disposé dans le réservoir de liquide (14, 150) ;
(c) un laser (13) destiné à enlever les nanoparticules d'élément de métal ou de semi-conducteur à l'intérieur du liquide dans le réservoir de liquide (14, 150) ; et
(d) des moyens (100) destinés à appliquer sur le substrat le liquide contenant les particules de métal enlevées,
**caractérisée en ce que**
(e) la galette de silicium ou l'autre substrat (110) est disposé(e) à l'extérieur du réservoir de liquide (14, 150) ;
(f) le liquide (1, 10) est formé d'un polymère durcissable ou d'un autre plastique durcissable,
(g) le réservoir de liquide comprend une chambre (150) qui se rétrécit de manière conique à l'extrémité inférieure et à l'extrémité inférieure de laquelle est prévu(e) un tube capillaire ou une buse (100) destiné (e) à appliquer sur le substrat (110) le liquide contenant les nanoparticules, les éléments de métal ou de semi-conducteur (80) étant disposés dans le réservoir de liquide dans la zone conique située avant la buse (100), et
(h) des moyens générateurs de courant (17, 30, 50) destinés à générer un courant de liquide sont prévus dans la zone dans laquelle sont enlevées les nanoparticules des éléments de métal ou de semi-conducteur (8, 80).

2. Disposition selon la revendication 1, **caractérisée en ce que** le métal (8, 80) est de l'or, de l'argent, du cuivre, du palladium, de l'aluminium, du nickel, de l'étain, un alliage de ces métaux ou un semi-conducteur à base de silicium.

3. Disposition selon la revendication 1 ou 2, **caractérisée en ce que** les moyens générateurs de courant sont formés d'une pompe (17).

4. Disposition selon la revendication 1 ou 2, **caractérisée en ce que** les moyens générateurs de courant comprennent un marteau à ultrasons (50) qui pousse le liquide à travers un passage (60) de diamètre réduit.

5. Disposition selon l'une quelconque des revendications précédentes, **caractérisée en ce que** la buse (100) est formée sur un réservoir fermé (150), le réservoir présentant une admission de liquide (60) par laquelle du liquide sous pression entre dans le réservoir.

6. Disposition selon l'une quelconque des revendications précédentes, **caractérisée en ce que** le réservoir est fermé du côté laser par une plaque de verre ou un autre recouvrement transparent.

7. Disposition destinée à appliquer des nanoparticules composées de métal ou d'un matériau semi-conducteur sur une galette de silicium ou un autre substrat (110), comprenant
(a) un réservoir de liquide (14, 150) contenant un liquide ;
(b) un élément de métal ou de semi-conducteur (8, 80) disposé dans le réservoir de liquide (14, 150) ;
(c) un laser (13) destiné à enlever les nanoparticules d'élément de métal ou de semi-conducteur à l'intérieur du liquide dans le réservoir de liquide (14, 150) ; et
(d) des moyens (100) destinés à appliquer sur le substrat le liquide contenant les particules de métal enlevées,
**caractérisée en ce que**
(e) la galette de silicium ou l'autre substrat (110) est disposé(e) à l'extérieur du réservoir de liquide (14, 150) ;
(f) le liquide (1, 10) est formé d'un polymère durcissable ou d'une autre matière plastique durcissable,
(g) le réservoir de liquide est formé d'une chambre (14)) dans laquelle le polymère ou la matière plastique peut être transporté(e) à l'aide d'une pompe depuis un réservoir (2) ; et
(h) la chambre (14) présente une épaisseur réduite dans la zone du rayon laser (12).

8. Disposition selon la revendication 7, **caractérisée en ce que** l'élément de métal ou de semi-conducteur (8) est disposé sur le fond de la chambre (14), la face supérieure de la chambre (14) est fermée par une plaque de verre et le rayon laser (12) est dirigé sur l'élément de métal ou de semi-conducteur (8) en traversant la plaque de verre de la chambre (14).
